Europäisches Patentamt

**European Patent Office**

**Office européen des brevets**

(19)

(11) Numéro de publication : **0 025 397**
**B1**

(12)

# FASCICULE DE BREVET EUROPÉEN

(45) Date de publication du fascicule du brevet :
**22.06.83**

(51) Int. Cl.³ : **G 03 B 41/00**

(21) Numéro de dépôt : **80401270.6**

(22) Date de dépôt : **05.09.80**

(54) **Dispositif illuminateur destiné à fournir un faisceau d'éclairement à distribution d'intensité ajustable et système de transfert de motifs comprenant un tel dispositif.**

(30) Priorité : **10.09.79 FR 7922587**

(43) Date de publication de la demande :
**18.03.81 Bulletin 81/11**

(45) Mention de la délivrance du brevet :
**22.06.83 Bulletin 83/25**

(84) Etats contractants désignés :
**CH DE GB LI NL SE**

(56) Documents cités :
**DE A 2 608 176**
**FR A 2 132 043**
**FR A 2 177 475**
**FR A 2 312 048**
**FR A 2 406 236**
**US A 3 584 948**
**US A 4 023 904**

(73) Titulaire : **THOMSON-CSF**
**173, Boulevard Haussmann**
**F-75379 Paris Cedex 08 (FR)**

(72) Inventeur : **Dubroeucq, Georges**
**"THOMSON-CSF" SCPI 173, bld Haussmann**
**F-75360 Paris Cedex 08 (FR)**
Inventeur : **Lacombat, Michel**
**"THOMSON-CSF" SCPI 173, bld Haussmann**
**F-75360 Paris Cedex 08 (FR)**
Inventeur : **Brevignon, Michèle**
**"THOMSON-CSF" SCPI 173, bld Haussmann**
**F-75360 Paris Cedex 08 (FR)**

(74) Mandataire : **Lepercque, Jean et al**
**THOMSON-CSF SCPI 173, Bld Haussmann**
**F-75379 Paris Cedex 08 (FR)**

# Dispositif illuminateur destiné à fournir un faisceau d'éclairement à distribution d'intensité ajustable et système de transfert de motifs comprenant un tel dispositif

La présente invention concerne un dispositif illuminateur destiné à fournir un faisceau d'éclairement quasi cohérent ayant une distribution spatiale d'intensité ajustable à volonté.

Un faisceau laser présente généralement une distribution d'intensité gaussienne à symétrie circulaire suivant la section due au fait que seul le mode fondamental résonne dans la cavité. Dans un dispositif illuminateur destiné à l'éclairement d'un objet, par exemple dans un système de projection de motifs, le faisceau issu du laser est élargi et rendu divergent. Il conserve sa distribution gaussienne, si bien que le centre de l'objet est éclairé plus intensément que les bords. Or, pour obtenir une bonne qualité d'image et également des largeurs de traits identiques dans tout le champ de l'objectif de projection, notamment lorsque les motifs sont projetés sur une résine photosensible, il faut une bonne uniformité d'éclairement dans le plan image. Ainsi, dans le cas de la réalisation de circuits intégrés par photorépétition directe, qui passe par la formation d'une superposition de niveaux dans un substrat semi-conducteur, avec masquages successifs, les traits les plus fins ont une largeur de l'ordre du micron. La dispersion de largeur de trait doit être inférieur à 10 %, ce qui implique des variations d'intensité d'éclairement inférieures à 3 %.

Différentes méthodes ont été proposées pour rendre un éclairement uniforme : la méthode la plus simple consiste à élargir suffisamment le faisceau pour n'utiliser que les rayons du centre. Cette méthode, pour être efficace, a un rendement énergétique de l'ordre de 1 %, ce qui supprime une grande partie de l'intérêt de l'utilisation d'un laser. D'autres méthodes faisant appel généralement à la dispersion ou à l'absorption du faisceau ont également un très faible rendement lumineux. Certaines méthodes ne présentent toutefois pas cet inconvénient. On peut utiliser un hologramme numérique tracé par ordinateur et approximant par une fonction binaire la transformation complexe donnant une répartition spatiale uniforme à partir d'une répartition gaussienne. Cette méthode est complexe et coûteuse à mettre en œuvre. On peut aussi tenir compte du fait que la répartition gaussienne est due au fait que le laser est monomode, et utiliser pour le laser des miroirs de rayon de courbure plus élevé, ce qui permet à d'autres modes de résonner. On obtient une répartition d'intensité avec un maximum moins accusé, mais on ne peut pas uniformiser suffisamment l'éclairement par ce moyen.

La présente invention permet d'obtenir un éclairement uniforme à moins de 5 % près, sans perte d'énergie, et avec des éléments optiques simples. De plus, le dispositif selon l'invention permet d'ajuster la distribution d'intensité, dans certaines limites, pour obtenir des éclairements non uniformes, mais correspondant au meilleur éclairement du plan image, en fonction des défauts du système optique de projection.

L'invention a donc pour objet un dispositif illuminateur destiné à fournir, à partir d'une source cohérente fournissant un faisceau initial se propageant suivant une direction parallèle à un axe déterminé et ayant une distribution d'intensité gaussienne suivant toute direction radiale à cet axe, un faisceau d'éclairement cohérent ayant une distribution spatiale d'intensité différente de la distribution initiale et ajustable dans un plan prédéterminé, caractérisé en ce qu'il comprend des moyens permettant la séparation du faisceau initial, selon deux directions radiales perpendiculaires entre elles, en quatre parties formant chacune un faisceau de rayons parallèles, des moyens permettant la recombinaison des quatre parties faiblement inclinées et décalées d'une même quantité par rapport audit axe de propagation, aboutissant dans le plan prédéterminé à une superposition partielle des quatre faisceaux, et des moyens permettant de moyenner les interférences entre les quatre parties de façon que l'intensité moyenne dans le plan prédéterminé soit égale à la somme des intensités moyennes des quatre parties.

D'autres caractéristiques et avantages de l'invention apparaîtront clairement à l'aide de la description ci-après et des figures annexées parmi lesquelles :

la figure 1 montre la répartition d'intensité d'un faisceau laser ;

la figure 2 représente schématiquement un dispositif illuminateur ;

la figure 3 représente schématiquement un dispositif de projection de motifs ;

la figure 4 illustre les répartitions d'intensité dans les plans objet et image ;

la figure 5 illustre schématiquement la méthode utilisée selon l'invention ;

la figure 6 représente un mode de réalisation de l'invention ;

les figures 7 et 8 sont des vues partielles détaillées ;

la figure 9 représente une variante de réalisation de l'invention ;

la figure 10 montre le résultat obtenu par le dispositif de la figure 6 ou de la figure 9 :

la figure 11 représente une application de l'invention ;

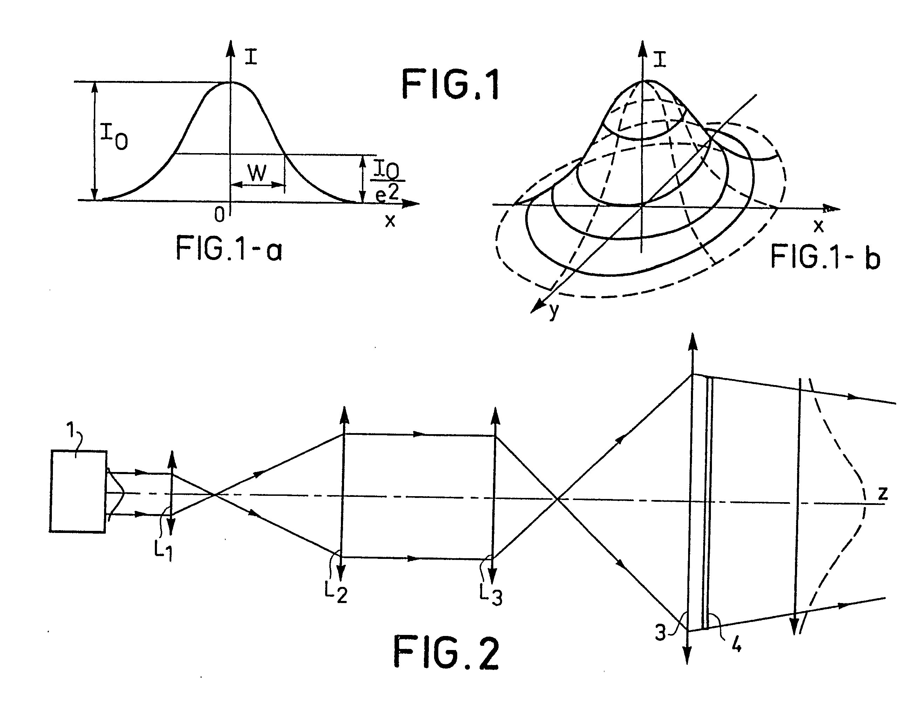

La figure 1 montre la répartition d'intensité d'un faisceau laser monomode. Un tel faisceau se caractérise essentiellement par sa très faible divergence (de l'ordre du milliradian) et une répartition d'intensité gaussienne suivant la section du faisceau. Ainsi, les rayons proches du centre du faisceau sont intenses, l'intensité sur l'axe central ayant une valeur $I_0$, tandis que les rayons des bords du faisceau sont de faible intensité. Les bords du faisceau peuvent être définis par leur distance radiale W, visible sur la figure 1a que l'on appelera rayon du faisceau telle que l'intensité soit égale à $I_0/e^2$.

La figure 1b montre que la distribution est à symétrie circulaire suivant la section du faisceau, constituée par le plan (x, y).

Un faisceau laser peut être utilisé dans un dispositif illuminateur tel que celui, représenté à titre d'exemple sur la figure 2. Le faisceau F délivré par le laser 1 et ayant la distribution d'intensité représentée sur la figure 1, est élargi par un expandeur formé de lentilles $L_1$ et $L_2$. Il est rendu divergent par une lentille $L_3$ et condensé par un condenseur 3 de façon à éclairer un objet 4. La distribution d'intensité dans le plan de l'objet reste gaussienne, si bien que les bords de l'objet sont moins éclairés que le centre. Or, suivant les applications, on désire obtenir une répartition d'intensité prédéterminée, adaptée à l'application.

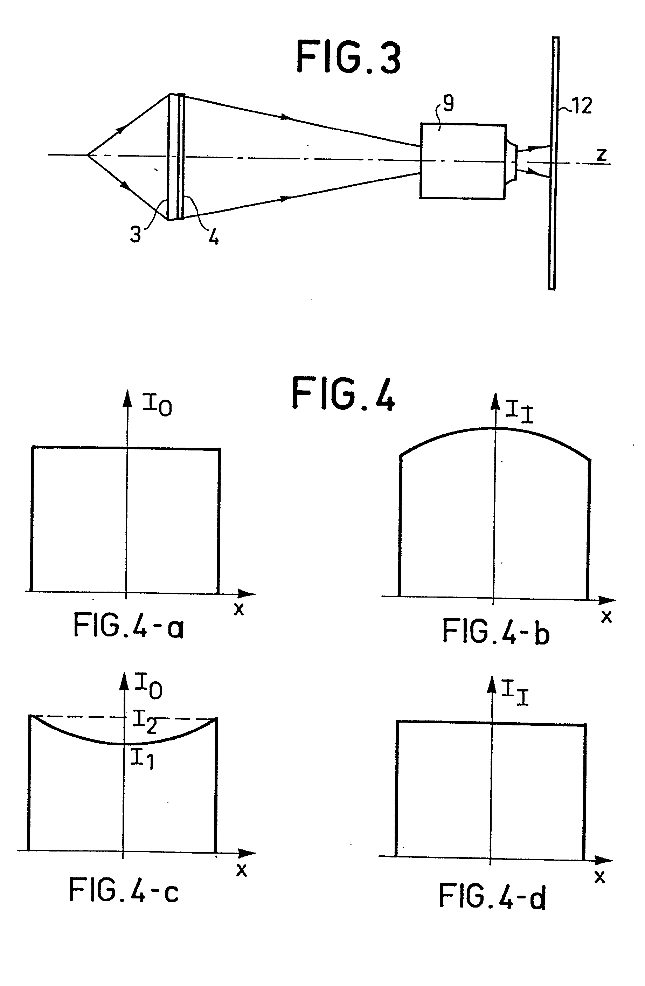

L'une des applications possibles est représentée sur la figure 3. Il s'agit d'un dispositif de projection comprenant notamment un objectif 9 formant l'image de l'objet 4 dans un plan 12. Pour obtenir une bonne qualité d'image dans tout le champ de l'objectif, il faut une bonne uniformité d'éclairement du plan image.

La figure 4 montre, dans deux cas, les répartitions d'intensité obtenues dans le plan image. Dans le premier cas, la répartition dans le plan objet, représentée en figure 4a, est uniforme. On constate alors généralement que l'éclairement dans le plan image représenté en figure 4b, est non uniforme, plus intense au centre et diminuant progressivement vers le bord du champ de l'objectif. Ceci est dû aux pertes lumineuses dans les différentes lentilles qui forment l'objectif 9 et qui sont en général plus grandes sur les bords qu'au centre, à cause de la forme sphérique des lentilles. En conséquence, pour avoir dans le plan image un éclairement uniforme, tel que représenté en figure 4d, il faut que l'éclairement dans le plan objet soit tel que représenté en figure 4c, moins intense au centre que sur les bords. Typiquement, l'écart maximum $I_2/I_1$ entre l'intensité au bord et au centre, doit être de 5 % à 10 %.

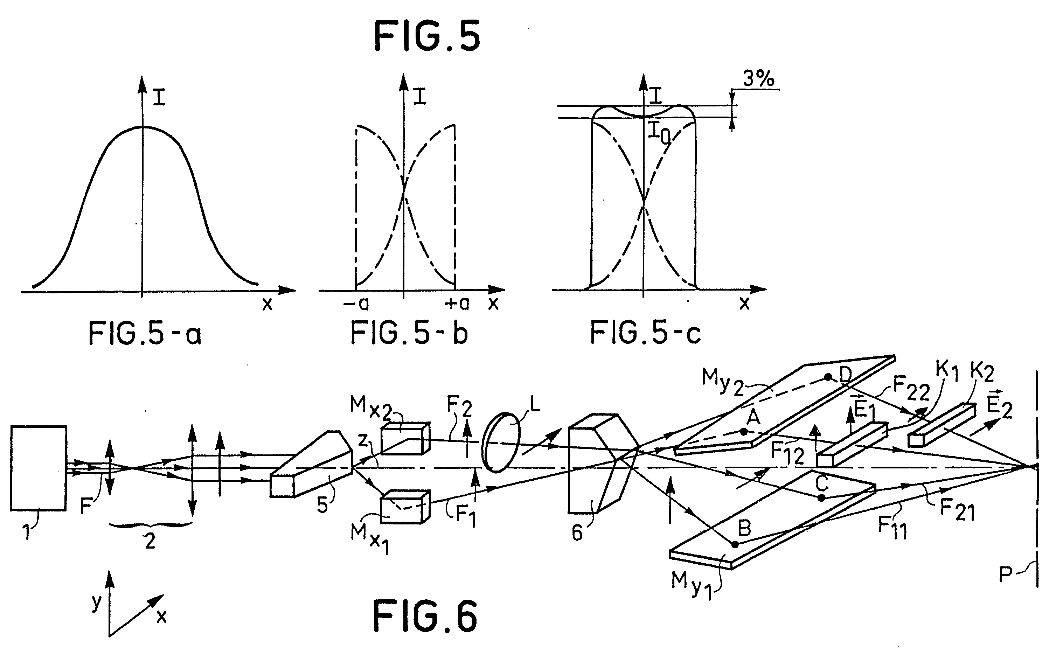

La figure 5 illustre schématiquement la méthode utilisée selon l'invention pour obtenir un éclairement du type de celui de la figure 4c. On verra par la suite que l'invention permet en outre d'obtenir d'autres formes d'éclairement voisines de l'éclairement uniforme.

Le faisceau d'origine F a dans toute direction radiale telle que x, une distribution d'intensité gaussienne représentée en figure 5a. L'invention prévoit de séparer ce faisceau en deux demi-faisceaux selon un plan axial perpendiculaire à l'axe x, puis de décaler les deux faisceaux obtenus d'une même quantité a, en sens inverse. Les deux demi-faisceaux se superposent, comme représenté en figure 5b, et on obtient un faisceau résultant dont la répartition d'intensité est représentée en figure 5c, à condition que les deux demi-faisceaux s'ajoutent en intensités, et non en phase et en amplitude, ce qui peut être obtenu par exemple, en faisant tourner la polarisation de l'un des demi-faisceaux de 90°. On constate que l'on aboutit à une répartition quasi uniforme suivant la direction x. Les calculs montrent que, pour a = 0,555 W, l'écart maximum d'intensité est de 3 %. Par contre, la répartition reste gaussienne suivant l'axe radial y perpendiculaire à x. Il est possible d'effectuer la même séparation-recombinaison suivant l'axe y, avec la même valeur pour le décalage. En supposant que l'on a fait en sorte que, dans la direction y également, les faisceaux s'ajoutent en intensité (la suite de la description montrera comment cela est possible), on montre que la forme du faisceau approche un carré, ce qui est souvent avantageux car les champs d'éclairement utiles des objets sont souvent carrés, d'où un gain en rendement lumineux. D'autre part, la répartition d'intensité est bien définie : plus faible au centre, elle augmente progressivement de $I_0$ à 103 % $I_0$ vers le bord suivant les axes x et y et de $I_0$ à 106 % $I_0$ vers le bord suivant les diagonales. Un tel faisceau fournit donc un éclairement proche de l'éclairement idéal, représenté sur la figure 4c.

La figure 6 représente un montage optique assurant la séparation-recombinaison d'un faisceau laser selon deux directions orthogonales, pour la réalisation de l'invention. Le faisceau laser F délivré par le laser 1 est élargi par un expandeur 2. La séparation suivant un axe x est assurée par un biprisme de Fresnel 5 convenablement orienté et centré par rapport au faisceau F. Le faisceau F est ainsi séparé en deux demi-faisceaux $F_1$ et $F_2$. Pour alléger la figure, on a représenté seulement les rayons résultant du rayon central du faisceau F, qui forme l'axe optique z du système. Les faisceaux $F_1$ et $F_2$ sont réfléchis respectivement par deux miroirs $M_{x1}$ et $M_{x2}$, de façon à les rendre quasi parallèles à l'axe z. Ils traversent alors un deuxième biprisme de Fresnel 6, orienté de façon orthogonale au biprisme 5 et qui assure la séparation de chaque faisceau $F_1$ et $F_2$ suivant l'axe y perpendiculaire à x, formant respectivement les faisceaux $F_{11}$ et $F_{12}$, $F_{21}$ et $F_{22}$. Les faisceaux $F_{11}$ et $F_{21}$ sont réfléchis par un miroir $M_{y1}$ et les faisceaux $F_{12}$ et $F_{22}$ sont réfléchis par un miroir $M_{y2}$, de façon à les rendre à nouveau quasi parallèles à l'axe z. Les miroirs $M_{y1}$ et $M_{y2}$ sont placés de façon que les points d'impact respectifs A, B, C, D des faisceaux $F_{12}$, $F_{11}$, $F_{21}$, $F_{22}$ soient vus sous une même inclinaison $\alpha$ par rapport à l'axe z, dans le plan de recombinaison P des faisceaux. C'est dans ce plan que pourra être placée la première lentille $L_1$ du dispositif d'éclairement de la figure 2. Pour conserver les propriétés collimatrices d'ensemble des deux lentilles $L_1$ et $L_2$ de la figure 2, il faut que l'angle $\alpha$ soit très faible.

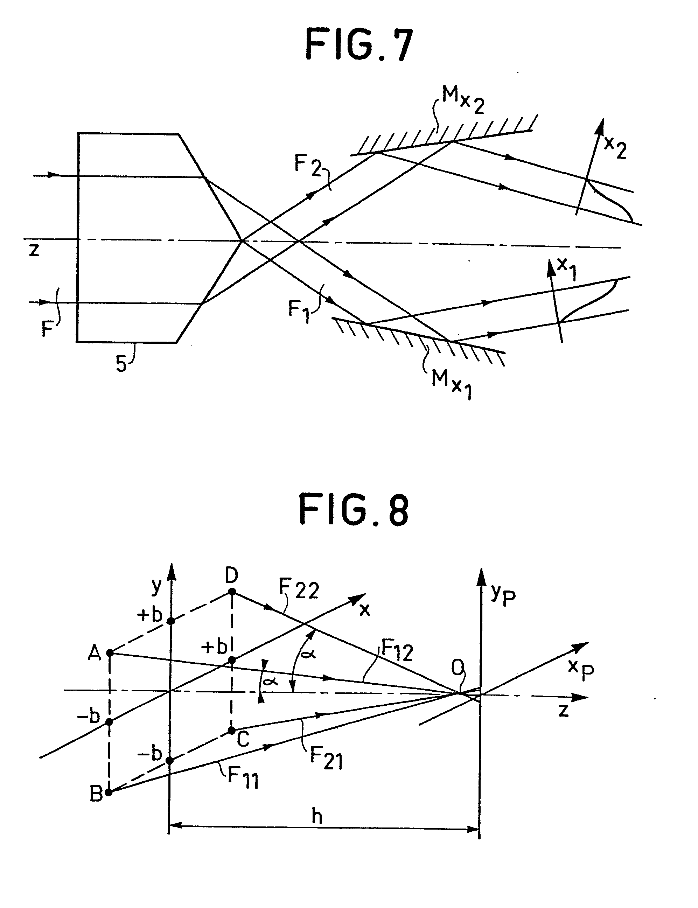

Le fonctionnement du premier séparateur constitué par le biprisme 5 et les miroirs $M_{x1}$ et $M_{x2}$ peut être expliqué à partir de la vue détaillée de la figure 7. Les faisceaux obtenus $F_1$ et $F_2$, ont respectivement, selon les axes $x_1$ et $x_2$ perpendiculaires à leur direction de propagation, des répartitions d'intensité en forme de demi-gaussienne, telles qu'illustrée sur la figure 5.

La figure 8 montre le trajet des faisceaux $F_{11}$, $F_{12}$, $F_{21}$, $F_{22}$ à la sortie du deuxième séparateur, constitué par le biprisme 6 et les miroirs $M_{y1}$ et $M_{y2}$. Les quatre points A, B, C, D forment un carré de côté 2b dans un plan x, y perpendiculaire à l'axe z centré sur l'axe z. Les rayons des faisceaux $F_{11}$, $F_{21}$, $F_{12}$, $F_{22}$ issus du rayon central du faisceau initial F forment le même angle $\alpha$ avec l'axe z. Ces quatre faisceaux forment dans le plan P un système d'interférences car les quatre sources sont cohérentes entre elles à cause de la cohérence du laser. Comme les quatre faisceaux ne sont pas parallèles à l'axe optique, on observe des franges orthogonales selon les axes $x_p$ et $y_p$ du plan P, formant une grille régulière. En agissant sur la polarisation des faisceaux, on peut faire en sorte que l'un des deux systèmes de franges soit supprimé. Par exemple, si l'on interpose une lame demi-onde L sur le trajet de faisceau $F_2$, le faisceau F étant déjà polarisé linéairement, on peut faire en sorte que les faisceaux $F_{22}$ et $F_{21}$ d'une part et $F_{11}$ et $F_{12}$ d'autre part soient polarisés respectivement selon des directions $P_2$ et $P_1$ perpendiculaires entre elles, et donc n'interfèrent plus. Toutefois, ces faisceaux interfèrent entre eux et forment deux systèmes de franges de même direction, indépendants et qui se superposent. Pour ces deux systèmes, il faut connaître les lois de répartition de phase des quatre faisceaux, d'après les lois de phase de différents éléments optiques traversés : la lame demi-onde et les deux biprismes, la réflexion sur les miroirs ne modifiant pas les répartitions de phase, et également, la modification observée dans le plan P due à l'inclinaison $\alpha$ des faisceaux, qui dépend de la valeur de l'angle $\alpha$, de b et de la distance h entre le plan P et le carré ABCD. On peut alors calculer les déphasages respectifs des quatre faisceaux. Si l'on introduit sur le trajet de l'un des faisceaux $F_{11}$ et $F_{12}$ un premier cristal électro-optique $K_1$ polarisé par un champ électrique parallèle à la direction de polarisation commune à ces deux faisceaux et dont la valeur varie dans le temps, on peut introduire un déphasage supplémentaire $\phi$ variable dans le temps et on peut faire en sorte que la valeur moyenne de cos $\phi$ sur une durée T faible devant la durée prévue pour que l'illumination soit nulle. Le calcul montre alors que la valeur moyenne de l'intensité résultante est égale à la somme des intensités de chacun des deux faisceaux. De même, on peut introduire sur le trajet de l'un des deux faisceaux $F_{21}$ et $F_{22}$ un deuxième cristal électro-optique $K_2$ polarisé par un champ électrique parallèle à la direction de polarisation commune à ces deux faisceaux et dont la valeur varie dans le temps, on peut faire le même raisonnement et montrer que, quand on considère la valeur moyenne, les deux faisceaux $F_{21}$ et $F_{22}$ s'ajoutent en intensité et non en amplitude et phase. Comme les faisceaux $F_{11}$ et $F_{12}$ d'une part, $F_{21}$ et $F_{22}$ d'autre part s'ajoutent en intensité ; du fait de leurs polarisations perpendiculaires, on a obtenu, non pas exactement une suppression des interférences, mais un moyennage dans le temps, sur une durée suffisamment faible par rapport à la durée d'éclairement ou d'observation pour que l'éclairement puisse être considéré comme homogène, par exemple quant à ses effets sur l'impression d'une résine photosensible.

La lame demi-onde L et les cristaux électro-optiques $K_1$ et $K_2$ sont représentés sur la figure 6, ainsi que les directions de polarisation des faisceaux, symbolisées par des flèches. Le faisceau F est polarisé parallèlement à l'axe y. La lame demi-onde L est placée sur le trajet du faisceau L dans un plan xy. Ses lignes neutres sont orientées à 45° des axes x, y, si bien que, à la sortie de la lame, la polarisation du faisceau $F_2$ est parallèle à l'axe x. Le cristal $K_1$ est placé sur le trajet du faisceau $F_{12}$ et il est commandé par un champ $E_1$ parallèle à la polarisation de ce faisceau, dont à l'axe y. Il génère un déphasage $\phi_1$, qui peut être par exemple égal à $\pi/2$ cos $2\pi t/T$. Le cristal $K_2$ est placé sur le trajet du faisceau $F_{22}$ et il est commandé par un champ $E_2$ parallèle à la polarisation de ce faisceau, dont à l'axe x. Il génère un déphasage $\phi_2$, qui peut être de la forme $\phi_2 = \pi/2$ cos $2\pi/T + \phi_0$ où $\phi_0$ a une valeur fixe quelconque.

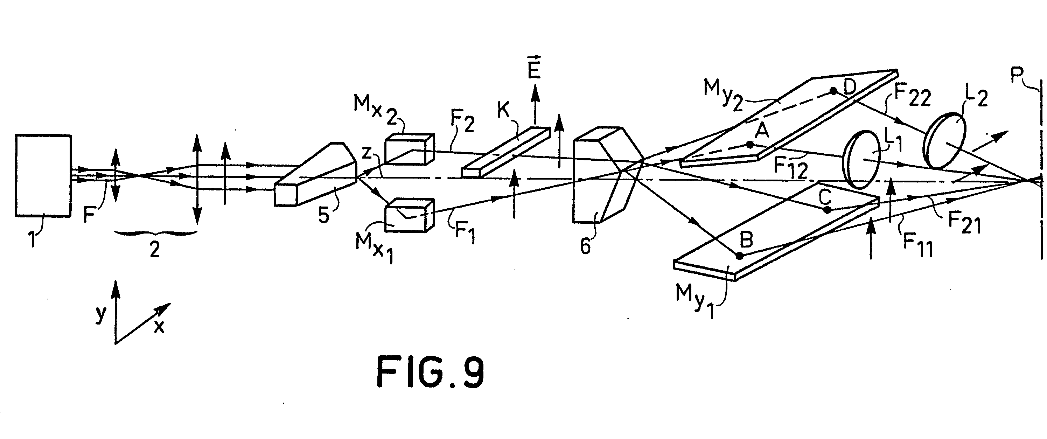

On obtient le même résultat de moyennage des interférences en intervertissant les deux moyens utilisés : lame demi-onde et déphaseurs. La figure 9 représente le même montage optique de séparation-recombinaison du faisceau, seuls les moyens permettant de moyenner les interférences étant différents. Le faisceau F étant toujours polarisé selon l'axe y, on introduit sur le trajet du faisceau $F_2$ un déphaseur constitué par un cristal électro-optique K polarisé par un champ électrique E parallèle à y, introduisant un déphasage $\phi$ entre les faisceaux $F_1$ et $F_2$ de la forme $\phi = \pi/2$ cos $2\pi/T$. Les directions de polarisation des deux faisceaux restent inchangés.

Une lame demi-onde $L_1$ est introduite sur le trajet du faisceau $F_{12}$ et une lame demi-onde $L_2$ est introduite sur le trajet du faisceau $F_{22}$, de façon que les polarisations de ces deux faisceaux deviennent parallèles à l'axe x. Ainsi, dans le plan P, les deux systèmes de franges sont supprimés. Cette méthode est moins onéreuse que la précédente car elle n'utilise qu'un déphaseur électrooptique au lieu de deux.

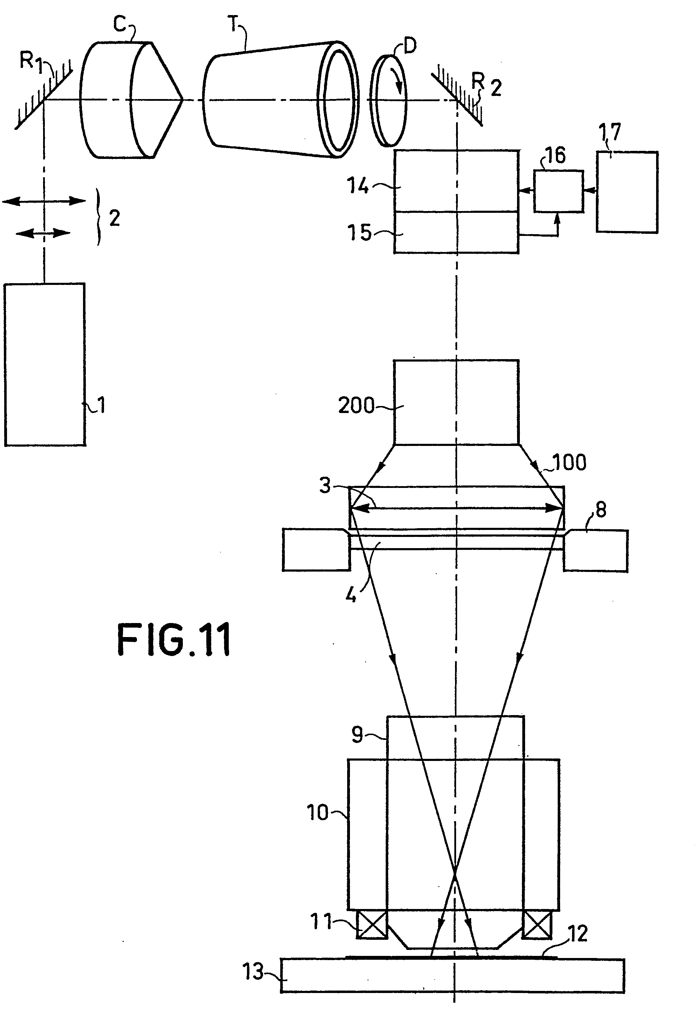

Une autre méthode possible pour supprimer l'effet dû aux interférences consiste à placer sur le trajet des faisceaux, un élément diffuseur tournant qui génère des déphasages variables dans le temps, spatialement aléatoire. Cette méthode sera avantageusement utilisée si, au lieu de réaliser séparément les deux séparateurs avec, pour chaque séparateur, un biprisme et deux miroirs, on réalise les séparations-recombinaisons respectivement au moyen d'un prisme à symétrie circulaire, ayant une forme conique et d'un miroir tronc-conique. Il s'agit de la généralisation du procédé qui vient d'être décrit. A la sortie du prisme conique le faisceau est transformé en un faisceau annulaire et recombiné par le miroir conique. De tels moyens sont illustrés par la figure 11 qui sera décrite ultérieurement.

Dans le cas où le faisceau laser n'est pas polarisé linéairement, l'utilisation d'une lame biréfringente n'est plus possible à moins d'interposer un polariseur sur le trajet du faisceau, ce qui occasionne une perte d'énergie de 50 %. On peut placer sur le trajet des quatre faisceaux quatre déphaseurs électro-optiques créant des déphasages respectifs, par exemple de la forme :

$$\phi_1 = \pi/2 \cos \omega t,$$
$$\phi_2 = \pi/2 \cos 2 \omega t,$$
$$\phi_3 = \pi/2 \cos 3 \omega t,$$
$$\phi_4 = \pi/2 \cos 4 \omega t,$$

où $T = 2\pi/\omega$ est faible devant la durée d'éclairement.

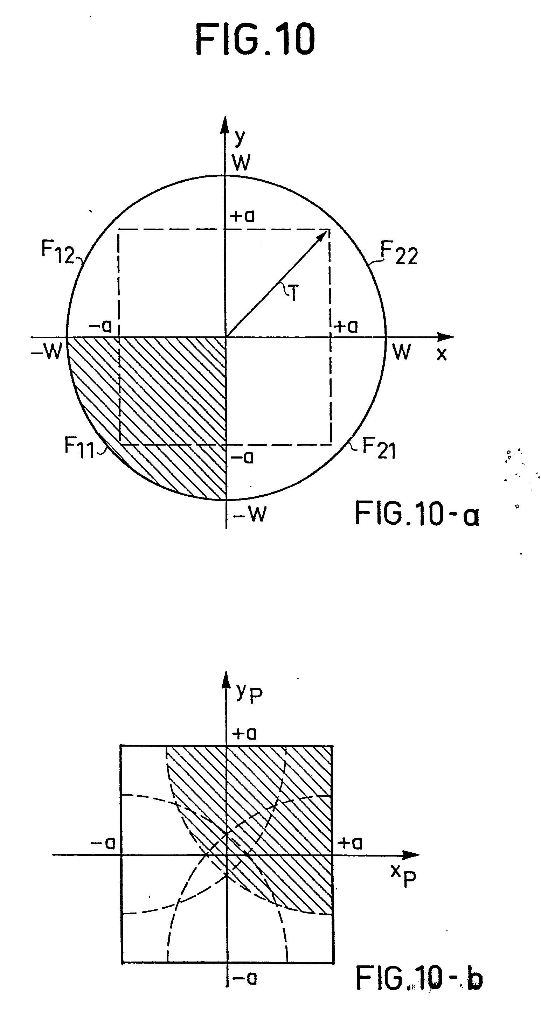

Quels que soient les moyens utilisés d'une part pour assurer la séparation-recombinaison de quatre faisceaux, d'autre part pour supprimer l'effet des interférences entre les quatre faisceaux, la séparation et le recombinaison sont illustrées sur les figures 10a et 10b. La section du faisceau F est représentée sur la figure 10a. Le dispositif selon l'invention décompose ce faisceau en quatre secteurs, puis réalise des translations de type $(\pm a, \pm a)$. Ainsi, le faisceau $F_{11}$, hachuré sur la figure est translaté selon le vecteur $T (+ a, + a)$. Dans le plan P, représenté sur la figure 10b, les quatre faisceaux superposés s'inscrivent dans un carré de côté 2a centrés sur l'axe z.

La valeur de a est déterminée par la distance h. Si le plan P passe par le point de rencontre O des quatre rayons issus du rayon central du faisceau F, il n'y a aucune superposition, a = O : le faisceau F se reconstitue. Plus la distance h augmente, plus la superposition est importante. Il a été dit précédemment que, lorsque a est de l'ordre de 0,5 W, on obtient une répartition d'intensité sensiblement uniforme. Pour des valeurs de a inférieures, la répartition d'intensité est en forme de « selle de cheval », c'est-à-dire que le faisceau est intense sur les bords et au centre, et moins intense sur des lieux intermédiaires. Pour des valeurs de a supérieurs, la répartition est en forme de cuvette : plus intense sur les bords qu'au centre.

Un dispositif illuminateur comprenant des moyens d'uniformisation du faisceau est applicable notamment à un photorépéteur.

La figure 11 représente un photorépéteur du type de celui décrit dans la demande de brevet français n° 76 37 327 et publiée sous le n° 2 406 236. Derrière le laser 1, par exemple un laser Krypton de puissance 1,5 W, sont disposés l'expandeur de faisceau 2, un premier miroir de renvoi $R_1$ et les moyens d'uniformisation, constitués par un prisme conique C, un élément T en forme de tronçon de cone à parois réfléchissantes et un diffuseur tournant D. Le faisceau ayant ainsi la distribution d'intensité désirée est renvoyé par un deuxième miroir $R_2$ vers un obturateur 14 commandé de façon à ce que la quantité d'énergie reçue par la couche de résine photosensible destinée à être impressionnée corresponde à la meilleure insolation possible. Les moyens de commande décrit dans la première demande citée, sont principalement constitués par un intégrateur 15, un sélecteur de quantité d'énergie 17 et un dispositif comparateur 16 déclenchant l'ouverture et la fermeture de l'obturateur 14. Sont disposés ensuite sur le trajet du faisceau des moyens 200 destinés à produire une source quasi-ponctuelle de dimensions telles qu'il ne se produise pas de figures d'interférences gênantes.

Le faisceau divergent 100 issu des moyens 200 éclaire via un condenseur 3 l'objet 4 porté par un porte-objet 8 et dont l'image est formée par l'objectif 9 porté par un objectif 10 muni de moyens de focalisation automatique 11 sur le substrat 12 recouvert d'une résine photosensible et porté par une table mobile 13. L'éclairement obtenu grâce au prisme conique C et au miroir tronc-conique T permet, comme il a été montré plus haut, d'obtenir une bonne qualité d'image au niveau de la résine photosensible.

## Revendications

1. Dispositif illuminateur destiné à fournir, à partir d'une source (1) cohérente fournissant un faisceau initial (F) se propageant suivant une direction parallèle à un axe déterminé (Z) et ayant une distribution d'intensité (I) gaussienne suivant toute direction radiale (X, Y) à cet axe, un faisceau d'éclairement cohérent ayant une distribution spatiale d'intensité différente de la distribution initiale et ajustable dans un plan prédéterminé (P), caractérisé en ce qu'il comprend des moyens (5, 6) permettant la séparation du faisceau initial, selon deux directions radiales (X, Y) perpendiculaires entre elles, en quatre parties formant chacune un faisceau de rayons parallèles $(F_{11}$-$F_{22})$, des moyens $(M_{x1}$-$M_{y2})$ permettant la recombinaison des quatre parties faiblement inclinées et décalées d'une même quantité $(+ a, - a)$ par rapport audit axe de propagation (Z), aboutissant dans le plan prédéterminé (P) à une superposition partielle des quatre faisceaux $(F_{11}$-$F_{22})$, et des moyens (L, $K_1$, $K_2$) permettant de moyenner les interférences entre les quatre parties de façon que l'intensité moyenne dans le plan prédéterminé (P) soit égale à la somme des intensités moyennes des quatre parties.

2. Dispositif illuminateur selon la revendication 1, caractérisé en ce que les moyens de séparation comprennent un premier biprisme (5) centré sur le trajet du faisceau initial (F) et le séparant selon une première direction radiale x en des premier et second demi-faisceaux $(F_1$-$F_2)$ symétriques par rapport à l'axe (z) du faisceau initial (F), et un deuxième biprisme (6) centré sur le trajet des deux demi-faisceaux $(F_1$-$F_2)$ et les séparant respectivement, selon une seconde direction radiale (y) perpendiculaire à la première, en une première et une seconde parties $(F_{11}$-$F_{12})$ symétriques par rapport au premier demi-faisceau $(F_1)$ et en une troisième et une quatrième parties $(F_{21}$-$F_{22})$ symétriques par rapport au second demi-faisceau $(F_2)$.

3. Dispositif illuminateur selon la revendication 2, caractérisé en ce que les moyens de recombinaison comprennent un premier ($M_{x1}$) et un deuxième ($M_{x2}$) miroirs réfléchissant respectivement les deux demi-faisceaux ($F_1$-$F_2$) en deux directions symétriques par rapport à l'axe (z) du faisceau initial (F) et convergeant vers le deuxième biprisme (6), et un troisième ($M_{y1}$) et un quatrième ($M_{y2}$) miroirs réfléchissant respectivement les deux premières parties ($F_{11}$-$F_{21}$) et les deux dernières parties ($F_{12}$-$F_{22}$) en quatre directions symétriques par rapport à l'axe (z) du faisceau initial (z) et convergeant vers le plan prédéterminé (P).

4. Dispositif illuminateur selon la revendication 3, caractérisé en ce que, le faisceau initial (F) étant polarisé linéairement, les moyens de moyennage comprennent au moins une lame biréfringente (L) située sur le trajet de l'un des demi-faisceaux ($F_2$) de façon que ces deux demi-faisceaux aient des directions de polarisation perpendiculaires entre elles, et au moins deux éléments déphaseurs électro-optiques ($K_1$-$K_2$) situés respectivement sur les trajets d'une des deux premières parties ($F_{12}$) et d'une des deux dernières parties ($F_{21}$) et introduisant entre les deux premières parties ($F_{11}$-$F_{12}$) d'une part, et entre les deux dernières parties ($F_{21}$-$F_{22}$) d'autre part, des déphasages prédéterminés variable dans le temps, dont les valeurs moyennes, sur des durées faibles par rapport à la durée d'éclairement, sont nulles.

5. Dispositif illuminateur selon la revendication 3, caractérisé en ce que, le faisceau initial étant polarisé linéairement, les moyens de moyennage comprennent au moins un élément déphaseur électro-optique (K) situé sur le trajet de l'un des deux demi-faisceaux ($F_2$) introduisant entre eux un déphasage prédéterminé variable dans le temps et dont la valeur moyenne est nulle sur une durée faible par rapport à la durée d'éclairement, et au moins deux lames biréfringentes ($L_1$-$L_2$) situées respectivement sur le trajet d'une des deux premières parties ($F_{12}$) et d'une des deux dernières parties ($F_{22}$) et y créant des rotations de polarisation de 90°.

6. Dispositif illuminateur destiné à fournir, à partir d'une source (1) cohérente fournissant un faisceau initial (F) se propageant suivant une direction parallèle à un axe déterminé (Z) et ayant une distribution d'intensité (I) gaussienne suivant toute direction radiale (X, Y) à cet axe, un faisceau d'éclairement cohérent ayant une distribution spatiale d'intensité différente de la distribution initiale et ajustable dans un plan prédéterminé (12), caractérisé en ce qu'il comprend des moyens (C) permettant la séparation dudit faisceau initial en des parties formant des demi-faisceaux de rayons parallèles selon une infinité de directions radiales, lesdits moyens (C) comprenant un prisme à symétrie circulaire en forme de cône dont l'axe est confondu avec l'axe de propagation (Z), des moyens (T) permettant la recombinaison des parties faiblement inclinées et décalées d'une même quantité par rapport audit axe de propagation (Z) de manière à obtenir une symétrie annulaire, aboutissant dans le plan prédéterminé (12) à une superposition partielle des faisceaux, et des moyens (D) permettant de moyenner les interférences entre les parties de façon que l'intensité moyenne dans le plan prédéterminé (12) soit égale à la somme des intensités moyennes des parties.

7. Dispositif illuminateur selon la revendication 6, caractérisé en ce que les moyens de recombinaison comprennent un élément troconique (T) à paroi interne réfléchissante, dont l'axe est confondu avec ledit axe de propagation du faisceau initial.

8. Dispositif illuminateur selon l'une quelconque des revendications 6 ou 7, caractérisé en ce que les moyens de moyennage comprennent un diffuseur tournant (D) placé sur le trajet du faisceau recombiné.

9. Système de transfert de motifs permettant de reproduire l'image d'un objet à transparence non uniforme (4) sur un substrat (12) recouvert d'une couche photosensible, ce système comprenant un dispositif illuminateur fournissant un faisceau d'éclairement de l'objet, et un objectif (9) formant l'image de l'objet sur le substrat, le système étant caractérisé en ce que le dispositif illuminateur est selon l'une quelconque des revendications précédentes.

**Claims**

1. Illumination device for providing a coherent illumination beam having a spatial intensity distribution which is different from the initial distribution and adjustable in a predetermined plane (P) from a coherent source (1) providing an initial beam (F) propagating along a direction parallel to a determined axis (Z) and having a Gaussian intensity distribution (I) along any radial direction (X, Y) with respect to this axis, characterized in that it comprises means (5, 6) allowing the separation of the initial beam along two radial, mutually perpendicular directions (X, Y) into four parts each forming a beam of parallel radiation ($F_{11}$-$F_{22}$), means ($M_{x1}$-$M_{y2}$) allowing the recombination of the four parts which are slightly inclined and shifted with respect to said propagation axis (Z) by the same quantity ($+ a$, $- a$), resulting into a partial superposition of the four beams ($F_{11}$-$F_{22}$) within the predetermined plane (P), and means (L, $K_1$, $K_2$) allowing to average the interferences between the four parts in such a manner that the average intensity within the predetermined plane (P) equals the sum of the average intensities of the four parts.

2. Illumination device in accordance with claim 1, characterized in that the separating means comprise a first twin-prism (5) centered on the path of the initial beam (F) and separating the latter along a first radial direction x into first and second half-beams ($F_1$-$F_2$) which are symmetrical with respect to the axis (z) of the initial beam (F), and a second twin-prism (6) centered on the path of the two half-beams ($F_1$-$F_2$) and separating the latter along a second radial direction (Y) perpendicular to the first into first and second parts ($F_{11}$-$F_{12}$), respectively, which are symmetrical with respect to the first half-beam ($F_1$) and into third and fourth parts ($F_{21}$-$F_{22}$) which are symmetrical with respect to the second half-beam ($F_2$).

3. Illumination device in accordance with claim 2, characterized in that the recombination means comprise first ($M_{x1}$) and second ($M_{x2}$) mirrors reflecting the two half-beams ($F_1$-$F_2$), respectively, into two directions which are symmetrical with respect to the axis (z) of the initial beam (F) and converge towards the second twin-prism (6), and third ($M_{y1}$) and fourth ($M_{y2}$) mirrors reflecting the two first parts ($F_{11}$-$F_{21}$) and the two last-mentioned parts ($F_{12}$-$F_{22}$), respectively, into four directions which are symmetrical with respect to the axis (z) of the initial beam (z) and converge towards the predetermined plane (P).

4. Illumination device in accordance with claim 3, characterized in that, the initial beam (F) being plane polarized, the averaging means comprise at least one birefringent plate (L) arranged on the path of one of the half-beams ($F_2$) in a manner to provide mutually perpendicular polarization directions of the two half-beams, and at least two electro-optic phase shifters ($K_1$-$K_2$) respectively arranged on the path of one of the two first-mentioned parts ($F_{12}$) and one of the two last-mentioned parts ($F_{21}$) and introducing, between the two first-mentioned parts ($F_{11}$-$F_{12}$) on the one hand and between the two last-mentioned parts ($F_{21}$-$F_{22}$) on the other hand, predetermined time variable phase shifts the average values of which, over durations which are short with respect to the illumination duration, equal zero.

5. Illumination device in accordance with claim 3, characterized in that, the initial beam being plane polarized, the averaging means comprise at least one electro-optic phase shifter (K) arranged on the path of one of the two half-beams ($F_2$) for introducing therebetween a predetermined time variable phase shift the average value of which equals zero over a duration which is short with respect to the illumination duration, and at least two birefringent plates ($L_1$-$L_2$) respectively arranged on the path of one of the two first-mentioned parts ($F_{12}$) and one of the two last-mentioned parts ($F_{22}$) where they cause 90° polarization twists.

6. Illumination device for producing a coherent illumination beam having a spatial intensity distribution which is different from the initial distribution and adjustable in a predetermined plane (12) from a coherent source (1) providing an initial beam (F) propagating along a direction parallel to a determined axis (Z) and having a Gaussian intensity distribution (I) along any radial direction (X, Y) with respect to this axis, characterized in that it comprises means (C) allowing the separation of said initial beam into parts forming half-beams of parallel radiation along an infinite number of radial directions, said means (C) comprising a cone shaped circular symmetry prism the axis of which is coincident with the propagation axis (Z), means (T) allowing the recombination of the slightly inclined paths which are shifted with respect to the propagation axis (Z) by the same quantity in a manner to obtain annular symmetry, resulting into a partial superposition of the beams within the predetermined plane (12), and means (D) allowing to average the interferences between the parts in such a manner that the average intensity within the predetermined plane (12) equals the sum of the average intensities of the parts.

7. Illumination device in accordance with claim 6, characterized in that the recombination means comprise a truncated cone element (T) having a reflecting interior wall the axis of which is coincident with said propagation axis of the initial beam.

8. Illumination device in accordance with any of claims 6 and 7, characterized in that the averaging means comprise a rotating diffusor (D) located on the path of the recombined beam.

9. Pattern transfer system for reproducing the image of a non-uniform transparency object (4) on a substrate (12) covered by a photosensitive layer, this system comprising an illumination device providing an object illumination beam and an objective (9) forming the image of the object on the substrate, the system being characterized in that the illumination device is formed in accordance with any of the preceding claims.

**Ansprüche**

1. Beleuchtungsvorrichtung, die dazu bestimmt ist, ausgehend von einer kohärenten Quelle (1), die ein Anfangsbündel (F) liefert, welches sich in einer Richtung parallel zu einer bestimmten Achse (Z) ausbreitet und eine Gaußsche Intensitätsverteilung (I) in allen Radialrichtungen (X, Y) zu dieser Achse aufweist, ein kohärentes Beleuchtungsbündel zu liefern, das eine räumliche Intensitätsverteilung aufweist, die verschieden von der Anfangsverteilung und in einer vorbestimmten Ebene (P) einstellbar ist, dadurch gekennzeichnet, daß sie Mittel (5, 6) umfaßt, welche die Trennung des Anfangsbündels in zwei aufeinander senkrechten radialen Richtungen (X, Y) und in vier Teile gestatten, die jeweils ein Bündel paralleler Strahlung ($F_{11}$-$F_{22}$) bilden, Mittel ($M_{x1}$-$M_{y2}$) umfaßt, welche die Rekombination der vier gering geneigten und um dieselbe Größe (+ a, − a) in bezug auf die genannte Ausbreitungsachse (Z) verschobenen Teile ermöglichen, welche in der vorbestimmten Ebene (P) zu einer Teilüberlagerung der vier Bündel ($F_{11}$-$F_{22}$) führt, und Mittel (L, $K_1$, $K_2$) aufweist, die es gestatten, die Interferenzen zwischen den vier Teilen zu mitteln, so daß die mittlere Intensität in der vorbestimmten Ebene (P) gleich der Summe der mittleren Intensitäten der vier Teile ist.

2. Beleuchtungsvorrichtung nach Anspruch 1, dadurch gekennzeichnet, daß die Trennmittel ein erstes Doppelprisma (5), das auf die Bahn des Anfangsbündels (F) zentriert ist und es in einer ersten Radialrichtung x in ein erstes und ein zweites Halbbündel (F$_1$-F$_2$) trennt, die symmetrisch in bezug auf die Achse (z) des Anfangsbündels (F) sind, und ein zweites Doppelprisma (6) umfassen, das auf die Bahn der beiden Halbbündel (F$_1$-F$_2$) zentriert ist und diese jeweils in einer zweiten radialen Richtung (y), die senkrecht zu der erstgenannten ist, in einen ersten und in einen zweiten Teil (F$_{11}$-F$_{12}$) trennt, welche in bezug auf das erste Halbbündel (F$_1$) symmetrisch sind, sowie in einen dritten und einen vierten Teil (F$_{21}$-F$_{22}$) trennt, die symmetrisch in bezug auf das zweite Halbbündel (F$_2$) sind.

3. Beleuchtungsvorrichtung nach Anspruch 2, dadurch gekennzeichnet, daß die Rekombinationsmittel einen ersten (M$_{x1}$) und einen zweiten (M$_{x2}$) Spiegel umfassen, welche die beiden Halbbündel (F$_1$-F$_2$) in zwei Richtungen reflektieren, die symmetrisch in bezug auf die Achse (z) des Anfangsbündels (F) sind und zu dem zweiten Doppelprisma (6) hin konvergieren, sowie einen dritten (M$_{y1}$) und einen vierten (M$_{y2}$) Spiegel umfassen, welche die beiden ersten Teile (F$_{11}$-F$_{22}$) und die beiden letzteren Teile (F$_{12}$-F$_{22}$) in vier Richtungen reflektieren, die symmetrisch zur Achse (z) des Anfangsbündels (z) sind und zu der vorbestimmten Ebene (P) hin konvergieren.

4. Beleuchtungsvorrichtung nach Anspruch 3, dadurch gekennzeichnet, daß das Anfangsbündel (F) linear polarisiert ist und die Einrichtungen zum Mitteln wenigstens ein doppelbrechendes Plättchen (L), das auf dem Weg des einen der Halbbündel (F$_2$) liegt, so daß diese beiden Halbbündel zueinander senkrechte Polarisationsrichtungen aufweisen, und wenigstens zwei elektrooptische Phasenschieber (K$_1$-K$_2$) aufweist, die jeweils auf den Bahnen eines der beiden ersteren Teile (F$_{12}$) bzw. eines der beiden letzteren Teile (F$_{21}$) liegen und zwischen den ersteren Teilen (F$_{11}$-F$_{12}$) einerseits sowie zwischen den beiden letzteren Teilen (F$_{21}$-F$_{22}$) andererseits vorbestimmte Phasenverschiebungen einführen, die zeitlich variabel sind und deren Mittelwerte, die auf bezüglich der Beleuchtungsdauer kurze Dauern bezogen sind, den Wert Null haben.

5. Beleuchtungsvorrichtung nach Anspruch 3, dadurch gekennzeichnet, daß das Anfangsbündel linear polarisiert ist und die Einrichtung zum Mitteln wenigstens ein elektrooptisches Phasenschieberelement (K) umfaßt, das auf der Bahn eines der beiden Halbbündel (F$_2$) liegt und zwischen diesen eine vorbestimmte, zeitlich veränderliche Phasenverschiebung einführt, deren mittlerer Wert über eine Dauer, die in bezug auf die Beleuchtungsdauer gering ist, den Wert Null hat, und wenigstens zwei doppelbrechende Plättchen (L$_1$-L$_2$) aufweist, die jeweils auf der Bahn eines der beiden ersteren Teile (F$_{12}$) und eines der beiden letzteren Teile (F$_{22}$) angeordnet sind und dort Polarisationsdrehungen um 90° verursachen.

6. Beleuchtungsvorrichtung, die dazu bestimmt ist, ausgehend von einer kohärenten Quelle (1), die ein Anfangsbündel (F) liefert, welches sich in einer Richtung parallel zu einer bestimmten Achse (Z) ausbreitet und eine Gaußsche Intensitätsverteilung (I) in jeglicher Radialrichtung (X, Y) zu dieser Achse aufweist, ein kohärentes Beleuchtungsbündel zu erzeugen, das eine räumliche Intensitätsverteilung aufweist, die verschieden von der Anfangsverteilung und in einer vorbestimmten Ebene (12) einstellbar ist, dadurch gekennzeichnet, daß sie Mittel (C) umfaßt, welche die Trennung des genannten Anfangsbündels in Teile ermöglichen, die Halbbündel paralleler Strahlung in unendlich vielen Radialrichtungen bilden, wobei diese Mittel (C) ein kegelförmiges Kreissymmetrieprisma enthalten, dessen Achse mit der Ausbreitungsachse (Z) übereinstimmt, Mittel (T) aufweisen welche die Rekombination der gering geneigten und um dieselbe Größe in bezug auf die Ausbreitungsachse (Z) verschobenen Teile ermöglichen, so daß eine Ringsymmetrie erhalten wird, die in der vorbestimmten Ebene (12) zu einer Teilüberlagerung der Bündel führt, sowie Mittel (D) aufweisen, die es gestatten, die Interferenzen zwischen den Teilen zu mitteln, so daß die mittlere Intensität in der vorbestimmten Ebene (12) gleich der Summe der mittleren Intensitäten der Teile ist.

7. Beleuchtungsvorrichtung nach Anspruch 6, dadurch gekennzeichnet, daß die Rekombinationsmittel ein kegelstumpfförmiges Element (T) mit reflektierender Innenwandung umfassen, dessen Achse mit der genannten Ausbreitungsachse des Anfangsbündels übereinstimmt.

8. Beleuchtungsvorrichtung nach Anspruch 6 oder 7, dadurch gekennzeichnet, daß die Einrichtung zum Mitteln einen rotierenden Diffusor (D) umfaßt, der auf der Bahn des rekombinierten Bündels angeordnet ist.

9. Motivübertragungssystem zum Reproduzieren des Bildes eines Objektes (4) ungleichförmiger Transparenz auf einem Substrat (12), das mit einer photoempfindlichen Schicht bedeckt ist, wobei dieses System eine Beleuchtungsvorrichtung aufweist, die ein Objektbeleuchtungsbündel liefert, und ein das Bild des Objektes auf dem Substrat erzeugendes Objektiv (9) umfaßt, wobei das System dadurch gekennzeichnet ist, daß die Beleuchtungsvorrichtung gemäß einem der vorstehenden Ansprüche ausgebildet ist.

FIG.1

FIG.1-a

FIG.1-b

FIG.2

0 025 397

# FIG.3

# FIG.4

FIG.4-a

FIG.4-b

FIG.4-c

FIG.4-d

FIG.5

FIG.5-a

FIG.5-b

FIG.5-c

FIG.6

# FIG.7

# FIG.8

FIG.9

0 025 397

# FIG.10

FIG.10-a

FIG.10-b

FIG.11